# EUROPEAN PATENT APPLICATION

(11) **EP 4 737 927 A1**
(43) Date of publication of application: **06.05.2026**
(21) Application number: 24860251.8
(22) Date of filing: 12.08.2024
(51) Int. Cl.: G01R 31/396, G01R 31/382, G01R 31/36, G07C 5/02, G07C 5/08, B60L 58/10, G06F 16/906, G06F 17/10

(54) **SERVER AND OPERATION METHOD THEREOF**

(30) Priority: 30.08.2023 KR 20230114896
(71) Applicant: LG Energy Solution, Ltd., Seoul 07335 (KR)
(72) Inventor: KIM, Kang San, Daejeon 34122 (KR); KIM, Geum Bee, Daejeon 34122 (KR); YOO, Ji Won, Daejeon 34122 (KR); HEO, Jung Eun, Daejeon 34122 (KR)
(74) Representative: Goddar, Heinz J.
(86) International application number: PCT/KR2024/011995
(87) International publication number: WO 2025/048330

(57) **Abstract**

According to an embodiment disclosed herein, a server may include a communication circuit, a memory, and a processor operatively connected to the communication circuit and the memory, wherein the processor may be configured to acquire pieces of time series data for a plurality of factors related to a battery for each user, generate feature data representing the relationship between at least two factors that are expected to have a mutual correlation among the plurality of factors based on each time series data, and classify the pieces of feature data into a plurality of clusters and define a plurality of patterns based on characteristics of each cluster.

## Description

### [TECHNICAL FIELD]

### CROSS-REFERENCE TO RELATED APPLICATION

This application claims priority to and the benefit of Korean Patent Application No. 10-2023-0114896 filed in the Korean Intellectual Property Office on August 30, 2023, the entire contents of which are incorporated herein by reference.

### TECHNICAL FIELD

Embodiments disclosed herein relate to a server and a method of operating the same.

### [BACKGROUND ART]

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, the lithium-ion batteries have an advantage of having a much higher energy density than the conventional Ni/Cd batteries, the Ni/MH batteries, and the like. In addition, since the small and light-weight lithium ion batteries may be manufactured, the lithium ion batteries are used as a power source for mobile devices, and recently, the lithium ion batteries are attracting attention as a next-generation energy storage medium due to the expansion of the range of use to a power source for electric vehicles.

When such a battery is provided in a vehicle, it is common to collect and analyze battery data because there may be individual differences in the performance, lifetime, safety, etc. of the battery depending on the tendency of a vehicle driver. However, there is a problem that a large amount of data collected for each vehicle are present, and it is difficult to standardize the collected data because battery usage patterns of vehicle users are different.

### [DISCLOSURE]

### [TECHNICAL PROBLEM]

Embodiments disclosed herein are directed to providing a server and a method of operating the same, which may standardize a large amount of data and define a user's type considering composite factors.

Embodiments disclosed herein are also directed to providing a server and a method of operating the same, which may extract main factors related to an evaluation index of a battery.

The technical objects of the embodiments disclosed herein are not limited to the above-described technical objects, and other objects that are not described will be able to be clearly understood by those skilled in the art from the following descriptions.

### [TECHNICAL SOLUTION]

According to an embodiment disclosed herein, a server may include a communication circuit, a memory, and a processor operatively connected to the communication circuit and the memory, wherein the processor may be configured to acquire pieces of time series data for a plurality of factors related to a battery for each user, generate feature data representing the relationship between at least two factors that are expected to have a mutual correlation among the plurality of factors based on each time series data, and classify the pieces of feature data into a plurality of clusters and define a plurality of patterns based on characteristics of each cluster.

According to an embodiment, the processor may generate the feature data based on a joint probability density function (joint PDF) of the at least two factors.

According to an embodiment, the processor may be configured to calculate a joint probability mass function (joint PMF) for the at least two factors from the time series data, calculate the joint PDF by applying a kernel density function (KDE) to the joint PMF, and generate the feature data representing a joint probability density of the at least two factors.

According to an embodiment, the feature data may include two-dimensional (2D) contour image data representing the joint probability density of the at least two factors.

According to an embodiment, the processor may classify the pieces of feature data into the plurality of clusters based on the relationship between the at least two factors derived from the feature data and the distribution of each of the at least two factors.

According to an embodiment, the processor may be configured to fuse the pieces of feature data included in each cluster for each cluster to generate representative feature data, and define the plurality of patterns based on the relationship between the at least two factors derived from the representative feature data and the distribution of each of the at least two factors.

According to an embodiment, the processor may determine a plurality of types for classifying a user based on the plurality of defined patterns.

According to an embodiment, the processor may analyze the relationship with an evaluation index of the battery according to the plurality of types and extract a main factor related to the evaluation index among the plurality of factors.

According to an embodiment, the plurality of factors may include at least some of a charging start state of charge (SOC), a charging depth of discharge (DOD), a charging C-rate, a charging start temperature, a highest charging temperature, a charging start time, a charging start day, a traveling start time, a traveling distance, a traveling start temperature, a highest traveling temperature, traveling DOD, traveling speed distribution, a discharging time, and a discharging end day.

According to an embodiment, the processor may acquire the time series data from an on board device (OBD) provided in each user's vehicle.

According to an embodiment disclosed herein, a method of operating a server may include acquiring pieces of time series data for a plurality of factors related to a battery for each user, generating feature data representing the relationship between at least two factors that are expected to have a mutual correlation among the plurality of factors based on each time series data, and classifying the pieces of feature data into a plurality of clusters and defining a plurality of patterns based on characteristics of each cluster.

According to an embodiment, the generating of the feature data may include calculating a joint probability mass function (joint PMF) for the at least two factors from the time series data, calculating a joint probability density function (joint PDF) for the at least two factors by applying a kernel density function (KDE) to the joint PMF, and generating the feature data representing a joint probability density of the at least two factors.

According to an embodiment, the defining of the plurality of patterns may include classifying the pieces of feature data into the plurality of clusters based on the relationship between the at least two factors derived from the feature data and the distribution of each of the at least two factors, fusing the pieces of feature data included in each cluster for each cluster to generate representative feature data, and defining the plurality of patterns based on the relationship between the at least two factors derived from the representative feature data and the distribution of each of the at least two factors.

According to an embodiment, the method may further include determining a plurality of types for classifying a user based on the plurality of defined patterns.

### [ADVANTAGEOUS EFFECTS]

According to the server and the method of operating the same according to the embodiments disclosed herein, it is possible to standardize unstructured data and define patterns and types considering the composite factors.

In addition, according to the server and the method of operating the same according to the embodiments disclosed herein, it is possible to extract the main factors related to the evaluation index of the battery.

In addition, various effects that may be directly or indirectly identified through the present document can be provided.

### [DESCRIPTION OF DRAWINGS]

FIG. 1 is a view showing a data analysis system according to one embodiment disclosed herein.
FIG. 2 is a view showing an example of feature data generation according to one embodiment disclosed herein.
FIG. 3 is a view showing an example of a plurality of patterns according to one embodiment disclosed herein.
FIG. 4 is a block diagram showing a configuration of a server according to one embodiment disclosed herein.
FIG. 5 is a flowchart for describing a method of operating the server according to one embodiment disclosed herein.
FIG. 6 is a flowchart for describing a process of generating feature data according to one embodiment disclosed herein.
FIG. 7 is a flowchart for describing a process of defining the plurality of patterns according to one embodiment disclosed herein.

### [MODE FOR INVENTION]

Hereinafter, various embodiments of the present disclosure will be described with reference to the accompanying drawings. However, it should be understood that this is not intended to limit the present disclosure to specific embodiments and includes various modifications, equivalents, and/or alternatives of the embodiments of the present disclosure.

The singular form of a noun corresponding to an item in this document may include one item or a plurality of items unless the relevant context clearly dictates otherwise. In this document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. The terms such as "first," "second," "first," or "second" may simply be used to distinguish the corresponding component from another and do not limit the corresponding components in another aspect (e.g., importance or order). When a certain (e.g., a first) component is described as being "connected," "coupled," or "joined or "coupled" or "connected" to another (e.g., a second) component with or without the terms "functionally" or "communicatively," this means that the certain component may be connected to another component directly (e.g., in a wired manner), in a wireless manner, or through a third component.

Each (e.g., a module or a program) of components described herein may include a single object or a plurality of objects. According to various embodiments, one or more among the above-described corresponding components may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to various embodiments, operations performed by modules, programs, or other components may be executed sequentially, in parallel, repeatedly, or heuristically, or one or more of the operations may be executed in a different order or omitted, or one or more other operations may be added.

As used herein, the term "module," or "part" may include a unit implemented in hardware, software, or firmware and may be used interchangeably with terms such as logic, logic block, component, or circuit. The module may be an integrated part or a minimum unit of the parts or a portion thereof that performs one or more functions. For example, according to one embodiment, the module may be implemented in the form of an application-specific integrated circuit (ASIC).

Various embodiments of this document may be implemented as software (e.g., a program or application) including one or more commands stored in a storage medium (e.g., a memory) that may be read by a machine. For example, a processor of the device may fetch at least one command among one or more commands stored from a storage medium and execute the commands. This allows the device to be operated to perform at least one function according to the at least one fetched command. The one or more commands may include code generated by a compiler or code that may be executed by an interpreter. A device-readable storage medium may be provided in the form of a non-transitory storage medium. Here, "non-transitory storage medium" is a tangible device and only means not including a signal (e.g., electromagnetic waves), and this term does not distinguish between cases in which data is stored semi-permanently and temporarily in the storage medium.

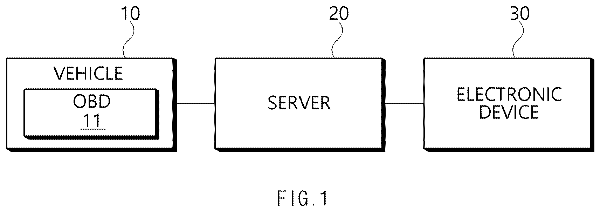

FIG. 1 is a view showing a data analysis system according to one embodiment disclosed herein.

Referring to FIG. 1, a data analysis system may include a vehicle 10, a server 20, and an electronic device 30.

The data analysis system may standardize a large amount of unstructured time series data collected from each user's vehicle and define a pattern that may represent the features of the data from the standardized data. In addition, the data processing system may determine a representative type to classify the user by combining a plurality of patterns defined from the standardized data.

A vehicle 10 may be an electric vehicle or hybrid electric vehicle provided with a battery. The battery may be a battery pack or a battery module and may include at least one battery cell and a battery management system (BMS) for monitoring and managing a status of a battery.

According to an embodiment, the vehicle 10 may be provided with an on-board device (OBD) 11 for collecting battery data, and the server 20 may acquire the battery data from the OBD 11. The battery data may comprehensively include data on the state of the battery (e.g., a state of charge (SOC), a state of health (SOH), a current, or a voltage), data on battery charging (e.g., a charging time, a temperature during charging, a charging end time, or a charging current distribution), data on a vehicle provided with a battery (e.g., a traveling time, a traveling distance, a speed, or acceleration), etc. and is not limited to the above-described examples. The OBD 11 may receive the battery data from the BMS or directly acquire the battery data.

The server 20 may acquire pieces of time series data on a plurality of factors related to the battery and define a plurality of patterns. For example, the server 20 may receive the pieces of time series data on the plurality of factors from the OBD 11 of the vehicle 10. As an example, the server 20 may acquire the pieces of time series data on a charging start SOC and charging depth of discharge (DOD) of the battery.

The server 20 may manage the acquired pieces of time series data by user or by vehicle 10. As an example, the server 20 may store and manage the pieces of time series data based on a unique ID assigned to each vehicle.

According to an embodiment, the plurality of factors may include at least some of the charging start SOC, the charging DOD, a charging C-rate, a charging start temperature, a highest charging temperature, a charging start time, a charging start day, a traveling start time, a traveling distance, a traveling start temperature, a highest traveling temperature, traveling DOD, traveling speed distribution, a discharging time, and a discharging end day. The plurality of factors are not limited thereto and may include factors that may affect the battery state, such as a traveling end state duration or an outside air temperature, without any limitation. For example, the plurality of factors may include a factor that may separate a charging section and a discharging section from the pieces of time series data and represent each section.

The server 20 may generate feature data from the pieces of time series data for at least two factors. For example, the at least two factors may be selected as factors that are expected to have a mutual correlation among the plurality of factors. As an example, the at least two factors may be selected as the charging start SOC - the charging DOD, which are expected to have a mutual correlation. In one embodiment, the server 20 may select two factors among the plurality of factors to generate feature data in order to clearly distinguish a difference between the visualization and pattern of the feature data.

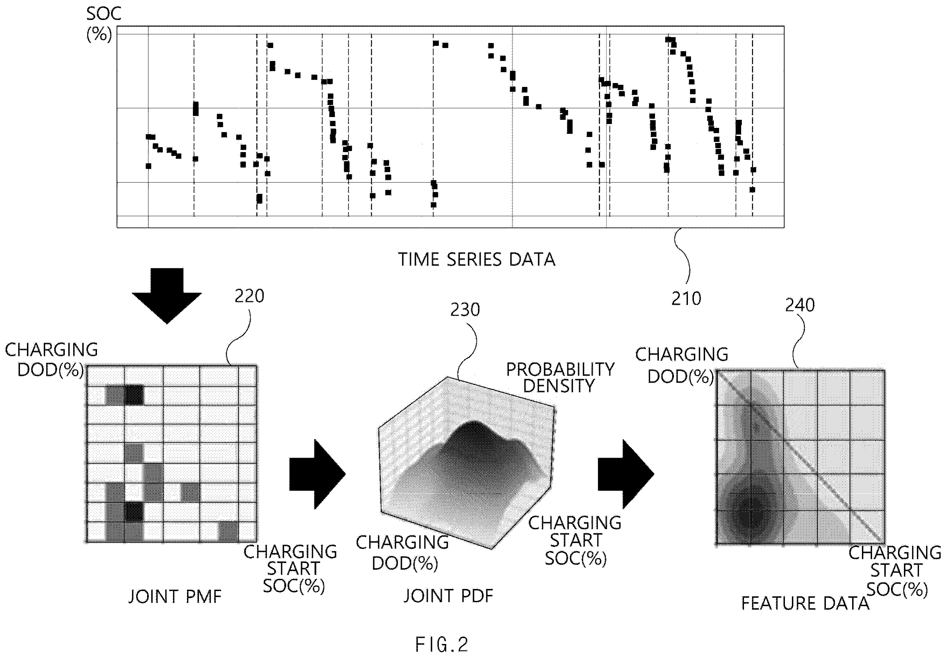

According to an embodiment, the server 20 may generate the feature data based on a joint probability density function (joint PDF) of the at least two factors. For example, the server 20 may generate feature data by representing the joint PDF as a graph. When the server 20 generates feature data based on only any one factor of the plurality of factors, each factor is not independent, and thus pattern definition results may be likely inaccurate and distorted. Therefore, the server 20 may generate feature data based on the joint PDF so that at least two factors that are not independent, that is, are expected to have a mutual correlation, may be complexly considered. An example of a specific method of generating feature data by the server 20 will be described below with reference to FIG. 2.

According to an embodiment, the feature data may include two-dimensional (2D) contour image data representing a joint probability density of at least two factors. The 2D contour image data may be image data in which the joint probability density is represented as contour data.

The server 20 may classify pieces of feature data into a plurality of clusters. For example, the server 20 may analyze the characteristics represented by the pieces of feature data and classify the pieces of feature data having similar characteristics to belong to the same cluster. The characteristics of the pieces of feature data may include, for example, the tendency, distribution, etc. of data values included in the feature data.

According to an embodiment, the server 20 may classify the pieces of feature data into the plurality of clusters based on the relationship between the at least two factors derived from the feature data and the distribution of each of the at least two factors. That is, the characteristics of the pieces of feature data may be analyzed using the relationship between the at least two factors and the distribution of each of the two factors.

The server 20 may define a plurality of patterns based on the characteristics of the classified clusters. The plurality of patterns may be patterns that may represent the features of pieces of data for the at least two factors.

According to an embodiment, the server 20 may fuse the pieces of feature data included in each cluster for each cluster to generate representative feature data. Here, the fusing of the pieces of feature data may mean representing the sum of the data values of the pieces of feature data. That is, the pieces of feature data may be data having the same size of dimension, and the server 20 may add the data values of the pieces of feature data. For example, the server 20 may represent outlines of pieces of data from the added data to generate representative feature data.

According to an embodiment, the server 20 may define a plurality of patterns based on the relationship between the at least two factors derived from the representative feature data and the distribution of each of the at least two factors. The server 20 may generate the representative feature data from the pieces of feature data included in the cluster and define the plurality of patterns therefrom to more clearly distinguish the tendency and representative characteristic of each pattern.

In this way, the server 20 may define the plurality of patterns for the selected factors. When pairs of factors selected from the plurality of factors are different, the plurality of patterns may also be defined differently. That is, the server 20 may define different patterns according to the pairs of the selected factors. For example, a pattern defined according to the charging start SoC - the charging DOD may differ from a pattern defined according to the charging DOD - the charging C-rate.

According to an embodiment, the server 20 may determine a plurality of types for classifying a user based on the defined plurality of patterns. The server 20 may determine the plurality of types by combining patterns defined according to pairs of different factors. For example, the server 20 may determine the plurality of types by combining a first pattern set defined according to the charging start SoC - the charging DOD and a second pattern set defined according to the charging start time - the charging start day.

The plurality of types for classifying the user may be represented, for example, as a combination of characters that may identify the users' tendencies. For example, the server 20 may express the user type using a combination of a plurality of characters to represent the user's vehicle use tendency, such as a Myers-Briggs Type Indicator (MBTI) that represents an individual's personality type. It goes without saying that the server 20 may express the user type in various ways, such as grades, graphs, symbols, and shapes expressed in numbers as well as a combination of letters.

As an example, the server 20 may classify the user's type into 'Preparation' or 'Margin' from the first pattern set defined according to the charging start SOC - the charging DOD. In another example, the server 20 may classify the user's type into 'Regularity' or 'Instant' from the second pattern set defined according to the charging start time - the charging start day. The server 20 may combine the above to classify the user's type into four types. The types and number of above-described user's types are only examples and are not limited thereto.

According to an embodiment, the server 20 may analyze the relationship with the evaluation index of the battery according to the plurality of types. For example, the server 20 may analyze the behavioral relevance between the evaluation index of the battery and a specific type. The evaluation index of the battery may include the lifetime (e.g., a SOH or remaining useful life (RUL)) of the battery, abnormal behavior frequency, average energy efficiency, etc.

According to an embodiment, the server 20 may extract main factors related to the evaluation index among the plurality of factors. The server 20 may analyze the evaluation index according to the user's type and identify a type that shows a high relevance with the evaluation index. For example, when a specific evaluation index is highly related to the type according to the pattern defined from the charging start SOC - the charging DOD, a main factor related to the corresponding evaluation index may be estimated as the charging start SOC and the charging DOD.

According to an embodiment, the server 20 may classify users according to the determined plurality of types. For example, the server 20 may provide the result of classifying the user's type to the user through the electronic device 30.

The electronic device 30 may be a user terminal carried by the user. The electronic device 30 may include various types of devices capable of performing data communication. For example, the electronic device 30 may include portable devices such as smartphones or tablets, computer devices such as desktops or laptops, multimedia devices, cameras, wearable devices, virtual reality (VR) devices, etc., and is not limited to the above-described devices. For example, the electronic device 30 may include a server or gateway that may transmit data packets through an application. The user may confirm his/her classified type through the electronic device 30.

FIG. 2 is a view showing an example of feature data generation according to one embodiment disclosed herein.

Referring to FIG. 2, the server 20 may generate feature data from pieces of time series data.

The server 20 may acquire pieces of time series data for a plurality of factors. For example, the server 20 may acquire the pieces of time series data from the OBD 11 provided in the vehicle 10. As an example, the pieces of time series data for the plurality of factors may be pieces of data acquired during a plurality of charging/discharging cycles. Pieces of time series data 210 shown in FIG. 2 exemplarily shows pieces of time series data for the charging start SOC and the charging DOD among the plurality of factors.

According to an embodiment, the server 20 may calculate a joint PMF 220 for at least two factors using the pieces of time series data for the at least two factors. For example, when the server 20 generates feature data for two factors, the joint PMF 220 may have an x-axis representing the first factor and a y-axis representing the second factor, and data of each coordinates may represent a data value of the first factor, a data value of the second factor, and a joint probability mass.

According to an embodiment, the server 20 may apply a kernel density function (KDE) to the generated joint PMF 220 and calculate a joint PDF 230. Since the statistics of the joint PMF 220 may be distorted by discrete values and the analysis may vary depending on the density of data, the server 20 may adopt the KDE and generate the joint PDF 230 for a consecutive domain.

According to an embodiment, the server 20 may generate feature data 240 representing the generated joint probability density. In an embodiment, the feature data may include 2D contour image data representing the joint probability density of at least two factors. For example, when the server 20 generates the feature data 240 for two factors, the x-axis of the feature data 240 may represent the first factor, the y-axis thereof may represent the second factor, and the data of each coordinates may represent the data value of the first factor, the data value of the second factor, and the joint probability density. As an example, in FIG. 2, a joint probability density at specific coordinates in the feature data 240 may be represented in color. That is, the darker the color of the coordinates in the feature data 240, the higher the probability density may be.

According to an embodiment, the server 20 may analyze the feature data. For example, by analyzing the feature data 240 shown in FIG. 2, it may be confirmed that the corresponding user has a low charging start SOC, a wide distribution of charging DOD, and a tendency for a low buffering ratio from the relationship between the charging start SOC and the charging DOD. The server 20 may analyze the characteristics of the feature data and classify the pieces of feature data into the plurality of clusters.

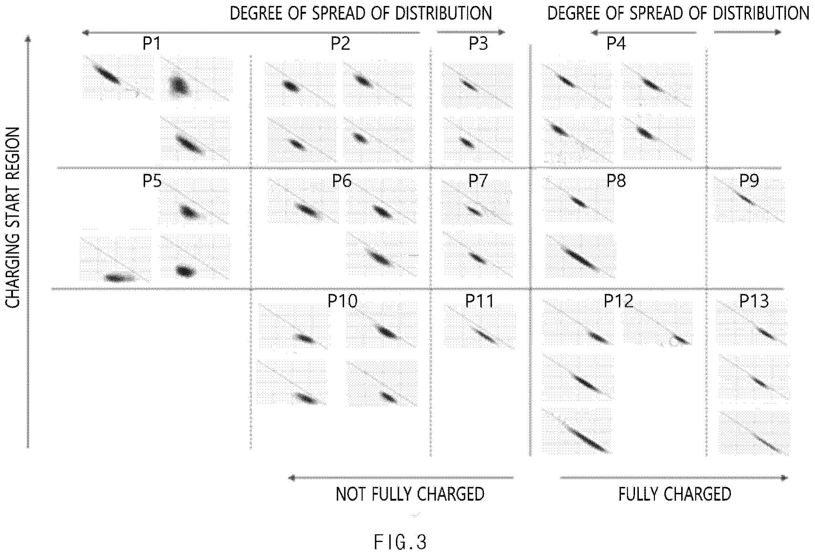

FIG. 3 is a view showing an example of a plurality of patterns according to one embodiment disclosed herein.

Referring to FIG. 3, the server 20 may define a plurality of patterns from pieces of representative feature data of the cluster.

The server 20 may fuse pieces of feature data belonging to each cluster and generate representative feature data. In FIG. 3, each of the graphs included in each pattern region represents representative feature data.

The server 20 may classify the pieces of representative feature data based on the relationship between the at least two factors and the distribution of each of the at least two factors and define a plurality of patterns. For example, the server 20 may define a plurality of patterns P1 to P13 according to the distribution (charging start region, degree of spread of distribution) of each factor and the relationship (whether to buffer) of the factor that are derived from the representative feature data as shown in FIG. 3. For example, the P13 pattern may represent that the user's charging start SOC is high, the degree of spread of the distribution of the charging DOD is low, and the tendency to buffer.

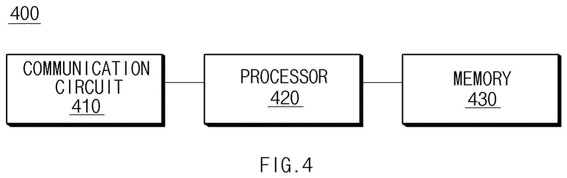

FIG. 4 is a block diagram showing a configuration of a server according to one embodiment disclosed herein.

Referring to FIG. 4, a server 400 (e.g., the server 20 of FIG. 1) according to one embodiment may include a first communication circuit 410, a first processor 420, and a first memory 430.

The first communication circuit 410 may support the establishment of a wired or wireless communication connection between the server 400 and an external electronic device (e.g., a vehicle or an electronic device) and the performance of communication through the established connection. According to one embodiment, the first communication circuit 410 may include a wireless communication circuit (e.g., a cellular communication circuit, a short range wireless communication circuit, or a global navigation satellite system (GNSS) communication circuit) or a wired communication circuit (e.g., a local area network (LAN) communication circuit or a power line communication circuit) and communicate with the external electronic device through a short range communication network, such as Bluetooth, WiFi direct, or infrared data association (IrDA), or a long distance communication network, such as a cellular network, an Internet, a computer network, using the corresponding communication circuit among the above communication circuits. Various types of the first communication circuits 410 may be implemented as one chip or may each be implemented as a separate chip. According to one embodiment, the first communication circuit 410 of the server 400 may communicate with the electronic device 30 and the vehicle 10 of FIG. 1.

The first processor 420 may control the overall operation of the server 400. In various embodiments, the first processor 420 may include one processor core (single core) or include a plurality of processor cores. For example, the processor 420 may include a multi-core, such as a dual-core, a quad-core, or a hexa-core. According to embodiments, the processor 420 may further include a cache memory located internally or externally. According to embodiments, the first processor 420 may be configured as one or more processors. For example, the first processor 420 may include at least one of an application processor, a communication processor, or a graphical processing unit (GPU).

All or some of the first processors 420 may be electrically or operatively coupled with or connected to other components (e.g., the first communication circuit 410 or the first memory 430) in the server 400. The first processor 420 may receive commands of other components, interpret the received commands, and perform calculations or process data according to the interpreted commands. The first processor 420 may interpret and process messages, data, commands, or signals received from the first communication circuit 410 and the first memory 430. The first processor 420 may generate new messages, data, commands, or signals based on the received messages, data, commands, or signals. The first processor 420 may provide the processed or generated messages, data, commands, or signals to the first communication circuit 410 or the first memory 430.

The first processor 420 may process data or signals generated or generated from a program. For example, the first processor 420 may request commands, data, or signals to the first memory 430 to execute or control the program. The first processor 420 may record (or store) or update the commands, data, or signals in the first memory 430 to execute or control the program. According to one embodiment, the first processor 420 may define the plurality of patterns from the pieces of time series data stored in the first memory 430.

The first memory 430 may store commands, control command codes, control data, or user data for controlling the server. For example, the first memory 430 may include at least one of an application program, an operating system (OS), middleware, and a device driver. The first memory 430 may include one or more of a volatile memory and a non-volatile memory. The volatile memory may include a dynamic random access memory (DRAM), a static RAM (SRAM), a synchronous DRAM (SDRAM), a phase-change RAM (PRAM), a magnetic RAM (MRAM), a resistive RAM (RRAM), a ferroelectric RAM (FeRAM), etc. The non-volatile memory may include a read only memory (ROM), a programmable ROM (PROM), an electrically programmable ROM (EPROM), an electrically erasable programmable ROM (EEPROM), a flash memory, etc. The memory 430 may further include a non-volatile medium such as a hard disk drive (HDD), a solid state disk (SSD), an embedded multi - media card (eMMC), or a universal flash storage (UFS). According to one embodiment, the first memory 430 may store the pieces of time series data acquired from the users' vehicles.

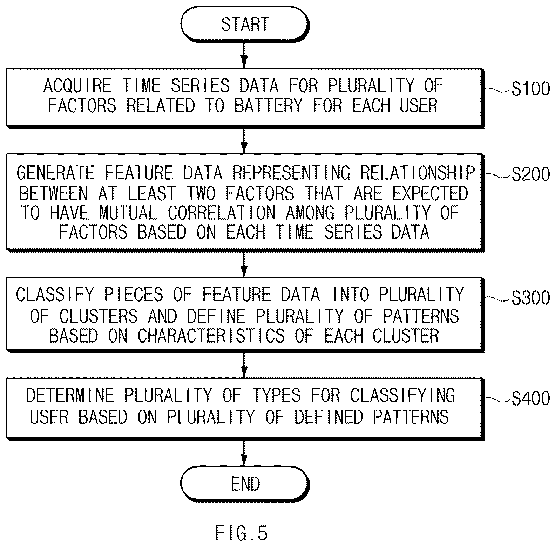

FIG. 5 is a flowchart for describing a method of operating the server according to one embodiment disclosed herein. The embodiment shown in FIG. 5 is only one embodiment, the order of operations according to various embodiments of the present disclosure may differ from that shown in FIG. 5, and some operations shown in FIG. 5 may be omitted, the order between the operations may be changed, or the operations may be merged.

Referring to FIG. 5, the method of operating a server may include acquiring pieces of time series data for a plurality of factors related to a battery for each user (S100), generating feature data representing the relationship between at least two factors that are expected to have a mutual correlation among the plurality of factors based on each time series data (S200), classifying the pieces of feature data into a plurality of clusters and defining a plurality of patterns based on characteristics of each cluster (S300), and determining a plurality of types for classifying a user based on the plurality of defined patterns (S400).

In operation S100, the server 20 may acquire the pieces of time series data for the plurality of factors related to the battery for each user. For example, the server 20 may acquire the pieces of time series data for each user from the OBD 11 provided in the vehicle 10.

In operation S200, the server 20 may generate feature data representing the relationship between at least two factors that are expected to have a mutual correlation among the plurality of factors based on each time series data. For example, the server 20 may select at least two factors among the plurality of factors and generate feature data based on a joint PDF of the at least two factors.

In operation S300, the server 20 may classify the pieces of feature data into a plurality of clusters and define a plurality of patterns based on the characteristics of each cluster. For example, the server 20 may classify the pieces of feature data into the plurality of clusters based on the relationship between the at least two factors derived from the feature data and the distribution of each of the at least two factors.

In operation S400, the server 20 may determine a plurality of types for classifying the user based on the plurality of defined patterns. For example, the server 20 may determine a plurality of types by combining a plurality of patterns defined according to combinations of factors selected from a plurality of factors.

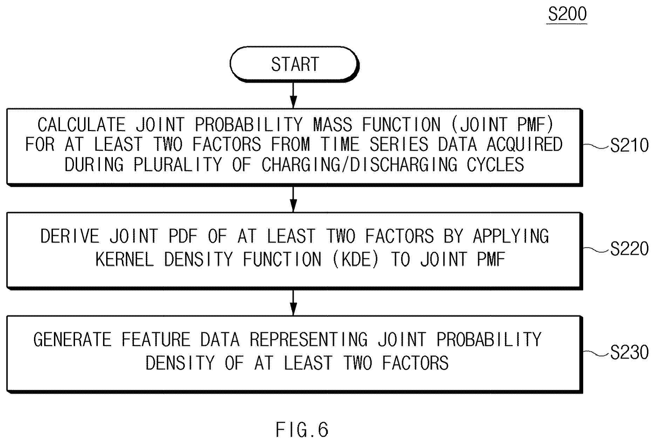

FIG. 6 is a flowchart for describing a process of generating feature data according to one embodiment disclosed herein.

Referring to FIG. 6, the server 20 may generate feature data representing the relationship between at least two factors.

In operation S210, the server 20 may calculate a joint probability mass function (PMF) for the at least two factors from time series data. For example, the time series data may be acquired during a plurality of charging/discharging cycles.

In operation S220, the server 20 may derive a joint PDF of the at least two factors by applying the KDE to the joint PMF.

In operation S230, the server 20 may generate the feature data representing the joint probability density of the at least two factors. For example, the feature data may include 2D contour image data.

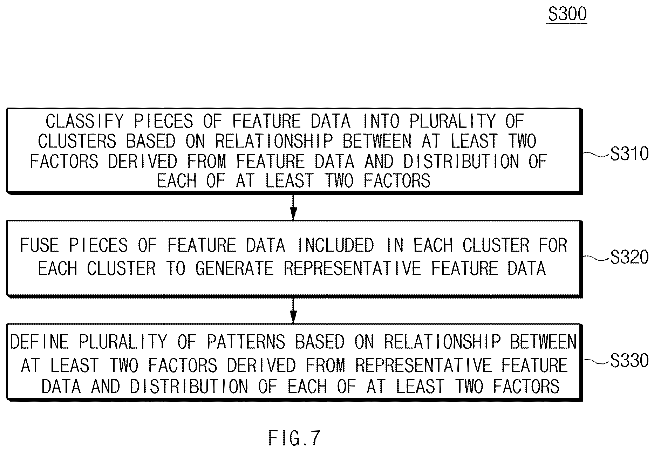

FIG. 7 is a flowchart for describing a process of defining the plurality of patterns according to one embodiment disclosed herein.

Referring to FIG. 7, the server 20 may define a plurality of patterns from the pieces of feature data.

In operation S310, the server 20 may classify the pieces of feature data into the plurality of clusters based on the relationship between the at least two factors derived from the feature data and the distribution of each of the at least two factors.

In operation S320, the server 20 may fuse the pieces of feature data included in each cluster for each cluster to generate representative feature data.

In operation S330, the server 20 may define a plurality of patterns based on the relationship between the at least two factors derived from the representative feature data and the distribution of each of the at least two factors.

As described above, although all the components constituting the embodiments disclosed herein were described as being coupled or operated by being coupled, the embodiments disclosed herein are not necessarily limited to these embodiments. In other words, one or more of all the components may be operated by being selectively coupled without departing from the scope of the purpose of the embodiments disclosed herein.

In addition, the terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of this document.

## Claims

1. A server comprising:
a communication circuit;
a memory; and
a processor operatively coupled to the communication circuit and the memory,
wherein the processor is configured to:
acquire pieces of time series data for a plurality of factors related to a battery for each user;
generate feature data representing the relationship between at least two factors that are expected to have a mutual correlation among the plurality of factors based on each time series data; and
classify the pieces of feature data into a plurality of clusters and define a plurality of patterns based on characteristics of each cluster.

2. The server of claim 1, wherein the processor generates the feature data based on a joint probability density function (joint PDF) of the at least two factors.

3. The server of claim 2, wherein the processor is configured to:
calculate a joint probability mass function (joint PMF) for the at least two factors from the time series data;
calculate the joint PDF by applying a kernel density function (KDE) to the joint PMF; and
generate the feature data representing a joint probability density of the at least two factors.

4. The server of claim 3, wherein the feature data includes two-dimensional (2D) contour image data representing the joint probability density of the at least two factors.

5. The server of claim 1, wherein the processor classifies the pieces of feature data into the plurality of clusters based on the relationship between the at least two factors derived from the feature data and the distribution of each of the at least two factors.

6. The server of claim 1, wherein the processor is configured to:
fuse the pieces of feature data included in each cluster for each cluster to generate representative feature data; and
define the plurality of patterns based on the relationship between the at least two factors derived from the representative feature data and the distribution of each of the at least two factors.

7. The server of claim 1, wherein the processor determines a plurality of types for classifying a user based on the plurality of defined patterns.

8. The server of claim 7, wherein the processor analyzes the relationship with an evaluation index of the battery according to the plurality of types and extracts a main factor related to the evaluation index among the plurality of factors.

9. The server of claim 1, wherein the plurality of factors include at least some of a charging start state of charge (SOC), a charging depth of discharge (DOD), a charging C-rate, a charging start temperature, a highest charging temperature, a charging start time, a charging start day, a traveling start time, a traveling distance, a traveling start temperature, a highest traveling temperature, traveling DOD, traveling speed distribution, a discharging time, and a discharging end day.

10. The server of claim 1, wherein the processor acquires the time series data from an on board device (OBD) provided in each user's vehicle.

11. A method of operating a server, comprising:
acquiring pieces of time series data for a plurality of factors related to a battery for each user;
generating feature data representing the relationship between at least two factors that are expected to have a mutual correlation among the plurality of factors based on each time series data; and
classifying the pieces of feature data into a plurality of clusters and defining a plurality of patterns based on characteristics of each cluster.

12. The method of claim 11, wherein the generating of the feature data includes:
calculating a joint probability mass function (joint PMF) for the at least two factors from the time series data;
calculating a joint probability density function (joint PDF) for the at least two factors by applying a kernel density function (KDE) to the joint PMF; and
generating the feature data representing a joint probability density of the at least two factors.

13. The method of claim 11, wherein the defining of the plurality of patterns includes:
classifying the pieces of feature data into the plurality of clusters based on the relationship between the at least two factors derived from the feature data and the distribution of each of the at least two factors;
fusing the pieces of feature data included in each cluster for each cluster to generate representative feature data; and
defining the plurality of patterns based on the relationship between the at least two factors derived from the representative feature data and the distribution of each of the at least two factors.

14. The method of claim 11, further comprising determining a plurality of types for classifying a user based on the plurality of defined patterns.
